(19) Europäisches Patentamt
European Patent Office
Office européen des brevets

(11) **EP 3 605 589 A1**

(12) **EUROPEAN PATENT APPLICATION**
published in accordance with Art. 153(4) EPC

(43) Date of publication:
**05.02.2020 Bulletin 2020/06**

(51) Int Cl.:
*H01L 21/304* [(2006.01)]   *B24B 37/00* [(2012.01)]
*C09G 1/02* [(2006.01)]   *C09K 3/14* [(2006.01)]

(21) Application number: **18776892.4**

(22) Date of filing: **28.02.2018**

(86) International application number:
**PCT/JP2018/007546**

(87) International publication number:
**WO 2018/180153 (04.10.2018 Gazette 2018/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **30.03.2017 JP 2017067956**

(71) Applicant: **Fujimi Incorporated**
**Kiyosu-shi, Aichi 452-8502 (JP)**

(72) Inventors:
• **TSUCHIYA, Kohsuke**
  **Kiyosu-shi**
  **Aichi 452-8502 (JP)**
• **TANIGUCHI, Megumi**
  **Kiyosu-shi**
  **Aichi 452-8502 (JP)**
• **NUMATA, Keisuke**
  **Kiyosu-shi**
  **Aichi 452-8502 (JP)**

(74) Representative: **Grünecker Patent- und Rechtsanwälte**
**PartG mbB**
**Leopoldstraße 4**
**80802 München (DE)**

(54) **POLISHING COMPOSITION AND POLISHING METHOD**

(57) The present invention provides a polishing composition capable of providing a silicon wafer with reduced roll off of an edge portion and improved overall flatness when performing rough polishing of the silicon wafer. The present invention is a polishing composition used for rough polishing a silicon wafer, containing: an abrasive; water-soluble polymers; a basic compound; and water, in which the water-soluble polymers include two or more polymers having different etching prevention ability to silicon.

**Description**

**TECHNICAL FIELD**

The present invention relates to a polishing composition used for rough polishing a silicon wafer and a polishing method using the polishing composition.

**BACKGROUND ART**

Heretofore, fine polishing using a polishing composition has been performed on the surface of materials such as metal, metalloid, nonmetal, and oxides thereof. For example, the surface of a silicon wafer used as a component of a semiconductor device is generally finished to a high quality mirror surface through a lapping step and a polishing step. The above-mentioned polishing step typically includes a preliminary polishing step and a final polishing step. The above-mentioned preliminary polishing step typically includes a rough polishing step (stock polishing step) and an intermediate polishing step (second polishing step).

In recent years, with the advancement of semiconductor devices with higher performance and higher integration, silicon wafers are required to have improved quality. For example, JP 2013-165173 A (corresponding to US 2015/014,579 A) discloses a polishing composition containing silicon dioxide, a nitrogen-containing water-soluble polymer, and a basic compound in a specific ratio, and describes that the polishing composition provides the silicon wafer in which the shape of an edge portion is maintained and the surface roughness and the level difference are reduced.

**SUMMARY OF INVENTION**

Technical Problem

However, when the silicon wafer is rough polished using the polishing composition described in JP 2013-165173 A (corresponding to US 2015/014,579 A), excessive polishing (roll off) of the wafer edge portion is reduced while the flatness of the entire wafer is still insufficient, and hence further quality improvement has been required.

The present invention has been made in view of the above circumstances, and has an object to provide a polishing composition which reduces roll off of an edge portion and improves overall flatness when performing rough polishing of a silicon wafer.

Solution to Problem

The present inventors have found that the above-mentioned problems can be solved by a polishing composition containing:
an abrasive; two or more water-soluble polymers having different etching prevention ability to silicon; a basic compound; and water, and have completed the present invention.

**DESCRIPTION OF EMBODIMENTS**

The present invention is a polishing composition used for rough polishing a silicon wafer, containing: an abrasive; water-soluble polymers; a basic compound; and water, in which the water-soluble polymers include two or more polymers having different etching prevention ability to silicon. When rough polishing of a silicon wafer is performed using the polishing composition according to the present invention, roll off of the edge portion is reduced and the overall flatness is improved. Here, the etching prevention ability to silicon is a value calculated by the method described later.

Generally, in a rough polishing step of a silicon wafer, a method for polishing the wafer while the wafer and a polishing pad are relatively moved (for example, rotationally moved) is used. The polishing pad is pressed against the surface of the wafer set in a polishing machine, and the polishing composition is continuously supplied. At this time, the polishing composition is supplied between the wafer and the polishing pad so as to flow mainly from the outer peripheral portion to the central portion of the wafer. The inventors of the present invention have found that both of the edge portion shape and the global flatness can be improved when a silicon wafer is rough polished with the polishing composition in which two or more water-soluble polymers having different etching prevention ability to silicon are blended.

In the process of supplying the polishing composition from the outer peripheral portion to the central portion of the wafer, the water-soluble polymer having high etching prevention ability to silicon (hereinafter also referred to as "first water-soluble polymer") is adsorbed on the surface of the wafer outer peripheral portion. With this, excessive polishing of the outer peripheral portion is prevented, sagging (edge roll off) of the edge portion is reduced, and the edge portion shape is improved. On the other hand, a water-soluble polymer having a lower etching prevention ability to silicon as compared to the first water-soluble polymer (hereinafter also referred to as "second water-soluble polymer") is not adsorbed to a larger extent on the surface of the wafer outer peripheral portion as compared to the first water-soluble polymer. Therefore, the second water-soluble polymer is higher in flowability than the first water-soluble polymer, and flows into the central portion and diffuses over the entire surface of the wafer. With this, the etching action of the entire wafer is controlled and the wafer is uniformly polished. Therefore, the flatness of the entire wafer is improved, and the entire shape is improved.

Note that, the above-mentioned mechanism is speculative, and the present invention is not limited to the above-mentioned mechanism.

In the present description, unless otherwise specified, measurements of operations, physical properties, and the like are performed under the conditions of room temperature (20 to 25°C)/Relative humidity 40 to 50% RH.

[Object to be polished]

The polishing composition according to the present invention is used for rough polishing of a silicon wafer. A silicon wafer excellent in the edge portion shape and the global flatness can be obtained by the action on the silicon surface of two or more kinds of water-soluble polymers having different etching prevention ability contained in the polishing composition.

Here, the silicon wafer may be made of a single silicon such as a single crystal silicon or a polycrystalline silicon, or may be formed of a layer consisting of a single silicon and other layers. In addition, it is acceptable for the silicon wafer to contain an element other than silicon at a content of the order of impurities. Therefore, the above-mentioned silicon wafer may contain a dopant such as boron or phosphorus.

Next, constituent components of the polishing composition of the present invention are described.

[Water-soluble polymer]

The polishing composition according to the present invention contains two or more kinds of water-soluble polymers having different etching prevention ability to silicon. Here, two kinds of water-soluble polymers are preferable. As described above, it is thought that the water-soluble polymer (first water-soluble polymer) having a high etching prevention ability to silicon is adsorbed on the surface of the wafer outer peripheral portion to prevent excessive polishing of the outer peripheral portion and to reduce sagging of the edge portion. On the other hand, the water-soluble polymer (second water-soluble polymer) having a lower etching prevention ability than the first water-soluble polymer diffuses over the entire surface of the wafer to control the etching action and to improve the flatness of the entire wafer.

Here, "the etching prevention ability to silicon" is a value calculated based on the following items 1 to 5:

1. Prepare a slurry for evaluation $L_{poly}$ containing 0.0008% by weight of a water-soluble polymer to be measured, 0.07% by weight of tetramethylammonium hydroxide, and 0.04% by weight of potassium carbonate, with the balance being hydrochloric acid and water. Add hydrochloric acid so that the pH of the slurry for evaluation is 11;

2. Immerse the silicon wafer in the above-mentioned slurry for evaluation $L_{poly}$ at 25°C for 24 hours;

3. Based on the weight of the wafer before and after immersion, the surface area of the wafer (area of the wafer surface before immersion) and the specific gravity of silicon, calculate an etching rate $R_{poly}$ based on the following equations (1) to (3). Here, the specific gravity of silicon is set to 2.33. ;

[Equation 1]

$$\Delta V = (W_0 - W_1)/d \quad (1)$$

$$\Delta x = \Delta V/S \quad (2)$$

$$R_{poly} = \Delta x/t \quad (3)$$

$\Delta V$: Wafer volume change amount before and after immersion
$W_0$: Wafer weight before immersion
$W_1$: Wafer weight after immersion
$d$: Specific gravity of silicon (2.33)
$S$: Wafer surface area

Δx: Wafer thickness change amount before and after immersion

t: Immersion time (24h)

4. Prepare a slurry for reference $L_{ref}$ in the same manner as in the above-mentioned item 1 except that the water-soluble polymer to be measured is not contained. Then, using the slurry for reference $L_{ref}$, calculate the etching rate $R_{ref}$ in the same manner as in the above-mentioned items 2 and 3;

5. From the $R_{poly}$ and $R_{ref}$ obtained above, calculate the etching prevention ability to silicon based on the following equation (4).

[Equation 2]

$$\text{Etching prevention ability to silicon (\%)} = (R_{ref} - R_{poly})/R_{ref} \times 100 \quad (4)$$

(First water-soluble polymer)

The etching prevention ability of the first water-soluble polymer to silicon is preferably 70% or more, more preferably 75% or more. Within such a range, excessive polishing of the wafer outer peripheral portion is prevented, and roll off of the edge portion is reduced, so that the edge portion shape is improved. Further, the etching prevention ability of the first water-soluble polymer to silicon is preferably 95% or less, more preferably 90% or less, still more preferably 85% or less, particularly preferably 80% or less. Within such a range, the wafer outer peripheral portion is appropriately polished, and the standing of the edge portion is prevented.

From the viewpoint of high etching prevention ability to the wafer outer peripheral portion, as the first water-soluble polymer, one containing a nitrogen atom is preferable, and one having an amide, azole, lactam, morpholine, and an amine structure as a monomer unit can be exemplified. As the first water-soluble polymer, there are given, for example, polyvinyl pyrrolidone (PVP), polyvinyl imidazole (PVI), polyvinyl carbazole, polyvinyl caprolactam, polyvinyl piperidine, polyacryloyl morpholine (PACMO), and the like. Among them, the first water-soluble polymer preferably contains at least one of polyvinyl pyrrolidone and polyvinyl imidazole, more preferably contains polyvinyl pyrrolidone from the viewpoint of further reducing roll off of the edge portion. These may be used alone or in combination of two or more. That is, in a preferred embodiment of the present invention, the first water-soluble polymer is polyvinyl pyrrolidone.

The weight average molecular weight of the first water-soluble polymer is preferably 3,000 or more, more preferably 5,000 or more, still more preferably 10,000 or more, still more preferably 15,000 or more, particularly preferably 17,000 or more. Further, the weight average molecular weight of the first water-soluble polymer is preferably 3,000,000 or less, more preferably 1,000,000 or less, still more preferably 500,000 or less, still more preferably 250,000 or less, particularly preferably 100,000. The weight average molecular weight can be measured using gel permeation chromatography (GPC) with polyethylene oxide as a standard substance.

(Second water-soluble polymer)

The etching prevention ability of the second water-soluble polymer to silicon is preferably less than 70%, more preferably less than 60%, still more preferably 55% or less. In addition, from the viewpoint of appropriately etching the entire wafer to further improve the flatness of the entire wafer, the etching prevention ability of the second water-soluble polymer to silicon is preferably more than 0%, more preferably 20% or more, still more preferably 30% or more, still further more preferably 40% or more, particularly preferably 50% or more.

From the viewpoint of suitably controlling the etching action of the entire wafer without excessively protecting the wafer, the second water-soluble polymer preferably contains at least one of a hydroxyl group and a carboxyl group, more preferably contains a hydroxyl group. As a specific example, there are given a polymer having a vinyl alcohol structure as a monomer unit or cellulose derivative, a polymer having a hydroxyalkyl (meth) acrylamide as a monomer unit, a polymer having a (meth) acrylic acid structure as a monomer unit, and the like. Among them, it is preferable to contain at least one selected from the group consisting of polyvinyl alcohol (PVA), hydroxyethyl cellulose (HEC), polyhydroxyethyl acrylamide, and polyacrylic acid (PAA), and from the viewpoint of further improving the flatness of the entire wafer, it is more preferable to contain polyvinyl alcohol. These may be used alone or in combination of two or more. That is, in a preferred embodiment of the present invention, the second water-soluble polymer is polyvinyl alcohol.

The weight average molecular weight of the second water-soluble polymer is preferably 3,000 or more, more preferably 5,000 or more. The weight average molecular weight of the second water-soluble polymer is preferably 2,000,000 or less, more preferably 1,500,000 or less. Among them, from the viewpoint of further enhancing the flatness of the entire wafer, the weight average molecular weight of the second water-soluble polymer is preferably less than 200,000, more preferably less than 100,000, still more preferably less than 50,000, particularly preferably, less than 15,000. The weight average molecular weight can be measured using gel permeation chromatography (GPC) with polyethylene oxide as a standard substance.

When the second water-soluble polymer contains polyvinyl alcohol, the saponification degree of the polyvinyl alcohol is preferably 80% or more and 100% or less, more preferably 90% or more and 100% or less, further more preferably 95% or more and 100% or less, particularly preferably 98% or more and 100% or less.

In the polishing composition of the present invention, the weight ratio of the first water-soluble polymer to the second water-soluble polymer (the weight of the first water-soluble polymer: the weight of the second water-soluble polymer) is preferably 5: 1 to 1: 5, more preferably 3: 1 to 1: 3. Among them, it is even more preferably 1: 1 to 1: 3, particularly preferably 1: 1 to 1: 2. Within such a range, a sufficient amount of the second water-soluble polymer diffuses over the entire surface of the wafer, so that the etching action of the entire wafer is better controlled. This further improves the flatness of the entire wafer. Note that, in addition, when two or more kinds of water-soluble polymers are used as the first water-soluble polymer, the total weight of these is regarded as the weight of the first water-soluble polymer. Similarly, when two or more kinds of water-soluble polymers are used as the second water-soluble polymer, the total weight of them is regarded as the weight of the second water-soluble polymer.

When the polishing composition is used as it is as a polishing solution, the content of the water-soluble polymers is preferably 0.0001% by weight or more, more preferably 0.0003% by weight or more, particularly preferably 0.0006% by weight or more with respect to the polishing composition. Within such a range, it is possible to obtain a silicon wafer excellent in the edge portion shape and the global flatness. Further, when the polishing composition is used as it is as the polishing solution, the content of the water-soluble polymers is 0.002% by weight or less, more preferably 0.001% by weight or less, particularly preferably 0.0008 % by weight or less. Within such a range, since a high polishing removal rate can be maintained, the polishing composition can be suitably used in a rough polishing step. The content of the water-soluble polymers refers to the total content of the first water-soluble polymer and the second water-soluble polymer.

Further, when the polishing composition is diluted and used for polishing, that is, when the polishing composition is a concentrated solution, the content of the water-soluble polymers is preferably 1% by weight or less from the viewpoint of storage stability, filterability, and the like. Further, from the viewpoint of taking advantage of the concentrated solution, the content of the water-soluble polymers is preferably 0.001% by weight or more.

[Abrasive]

The polishing composition of the present invention contains an abrasive(s). The abrasive contained in the polishing composition has a function of mechanically polishing a silicon wafer.

The abrasive used may be any of inorganic particles, organic particles, and organic-inorganic composite particles. As specific examples of the inorganic particles, there are given particles made of metal oxides such as silica, alumina, ceria, and titania, silicon nitride particles, silicon carbide particles, and boron nitride particles. As specific examples of the organic particles, for example, polymethyl methacrylate (PMMA) particles are given. The abrasive may be used alone or in combination of two or more kinds. Moreover, as the abrasive, a commercial item may be used, and a synthetic product may be used. Note that, in the present description, an abrasive refer to those which are not surface-modified unless otherwise specified.

Among these abrasives, silica is preferable, and colloidal silica is particularly preferable.

The lower limit of the average primary particle size of the abrasive(s) is preferably 10 nm or more, more preferably 15 nm or more, still more preferably 20 nm or more, still more preferably 30 nm or more, even more preferably 40 nm or more, particularly preferably 50 nm or more. Within such a range, since a high polishing removal rate can be maintained, the polishing composition is suitably used in a rough polishing step. Further, the upper limit of the average primary particle size of the abrasive(s) is preferably 200 nm or less, more preferably 150 nm or less, still more preferably 100 nm or less. Within such a range, generation of defects on the surface of the silicon wafer after polishing can be further suppressed. Note that, the average primary particle size of the abrasive(s) is calculated based on, for example, the specific surface area of the abrasive(s) measured by the BET method.

The lower limit of the average secondary particle size of the abrasive(s) is preferably 15 nm or more, more preferably 30 nm or more, still more preferably 50 nm or more, particularly preferably 70 nm or more. Within such a range, since a high polishing removal rate can be maintained, the polishing composition is suitably used in a rough polishing step. Further, the upper limit of the average secondary particle size of the abrasive(s) is preferably 300 nm or less, more preferably 260 nm or less, still more preferably 220 nm or less. Within such a range, generation of defects on the surface of the silicon wafer after polishing can be further suppressed. The average secondary particle size of the abrasive(s) can be measured, for example, by a dynamic light scattering method.

When the polishing composition is used as it is as a polishing solution, the content of the abrasive is preferably 0.1% by weight or more, more preferably 0.5% by weight or more, more preferably 1.0% by weight or more, particularly preferably 1.4% by weight or more with respect to the polishing composition. Since the polishing removal rate is improved by the increase of the content of the abrasive, the polishing composition can be suitably used in a rough polishing step. Further, the polishing composition is used as it is as a polishing solution, the content of the abrasive is suitably 10% by weight or less in general, preferably 5% by weight or less, more preferably 3% by weight or less, particularly preferably 2% by weight or less from the viewpoint of scratch prevention and the like. It is preferable from the economical point of view to reduce the content of the abrasive.

Further, when the polishing composition is diluted and used for polishing, that is, when the polishing composition is a concentrated solution, the content of the abrasive is suitably 50% by weight or less in general, more preferably 40% by weight or less from the viewpoint of storage stability, filterability, and the like. Further, from the viewpoint of taking advantage of the concentrated solution, the content of the abrasive is preferably 1% by weight or more, more preferably 5% by weight or more.

[Basic compound]

The polishing composition according to the present invention contains a basic compound. Here, the basic compound refers to a compound having a function of increasing the pH of the composition by being added to the polishing composition. The basic compound functions to chemically polish the surface to be polished and can contribute to the improvement of the polishing removal rate. Further, the basic compound can also help to improve the dispersion stability of the polishing composition.

As the basic compound, organic or inorganic basic compounds containing nitrogen, hydroxides of alkali metals or group 2 metals, various carbonates and hydrogen carbonates, and the like can be used. For example, there are given hydroxides of alkali metals, quaternary ammonium hydroxides or salts thereof, ammonia, amines, and the like. As specific examples of the hydroxides of alkali metals, there are given potassium hydroxide, sodium hydroxide, and the like. As specific examples of the carbonates or hydrogen carbonates, there are given ammonium hydrogen carbonate, ammonium carbonate, potassium hydrogen carbonate, potassium carbonate, sodium hydrogen carbonate, sodium carbonate, and the like. As specific examples of the quaternary ammonium hydroxides or salts thereof, there are given tetramethylammonium hydroxide, tetraethylammonium hydroxide, tetrabutylammonium hydroxide, and the like. As specific examples of the amines, there are given methylamine, dimethylamine, trimethylamine, ethylamine, diethylamine, triethylamine, ethylenediamine, monoethanolamine, N- (β-aminoethyl) ethanolamine, hexamethylenediamine, diethylenetriamine, triethylenetetramine, anhydrous piperazine, piperazine hexahydrate, 1- (2-aminoethyl) piperazine, N-methylpiperazine, guanidine, azoles such as imidazole and triazole, and the like.

From the viewpoint of improving the polishing removal rate and the like, as preferable basic compounds, there are given ammonia, potassium hydroxide, sodium hydroxide, tetramethylammonium hydroxide, tetraethylammonium hydroxide, ammonium hydrogen carbonate, ammonium carbonate, ammonium hydrogen carbonate, ammonium carbonate, potassium hydrogen carbonate, potassium carbonate, sodium hydrogen carbonate, and sodium carbonate. As more preferable ones among them, there are exemplified ammonia, potassium hydroxide, sodium hydroxide, tetramethylammonium hydroxide, and tetraethylammonium hydroxide. As further preferred ones, there are given potassium carbonate and tetramethylammonium hydroxide. Such basic compounds can be used alone or in combination of two or more. When two or more kinds are used in combination, for example, the combination of potassium carbonate and tetramethylammonium hydroxide is preferable.

When the polishing composition is used as it is as a polishing solution, the content of the basic compound is preferably 0.01% by weight or more, more preferably 0.05% by weight or more, still more preferably 0.1% by weight or more with respect to the polishing composition. Within such a range, since a high polishing removal rate can be maintained, the polishing composition is suitably used in a rough polishing step. Further, the stability can also be improved by increase of the content of the basic compound. Further, when the polishing composition is used as it is as a polishing solution, the upper limit of the content of the above-mentioned basic compound is suitably 1% by weight or less, preferably 0.5% by weight or less from the viewpoint of surface quality and the like. Further, when two or more kinds are used in combination, the content refers to the total content of two or more kinds of basic compounds.

Further, when the polishing composition is diluted and used for polishing, that is, when the polishing composition is a concentrated solution, from the viewpoint of storage stability, filterability, and the like, the content of the basic compound is suitably 10% by weight or less in general, more preferably 5% by weight or less. Further, from the viewpoint of taking advantage of the concentrated solution, the content of the basic compound is preferably 0.1% by weight or more, more preferably 0.5% by weight or more, still more preferably 0.9% by weight or more.

[Water]

The polishing composition according to the present invention contains water as a dispersion medium to disperse or dissolve each component. It is preferable that water does not contain impurities as much as possible from the viewpoint of preventing the contamination of the silicon wafer and the action of other components. As such water, for example, water having a total content of transition metal ions of 100 ppb or less is preferable. Here, the purity of water can be increased by operations such as removal of impurity ions using ion exchange resin, removal of foreign matter by using a filter, distillation, and the like. Specifically, as water, it is preferable to use, for example, deionized water (ion-exchanged water), pure water, ultrapure water, distilled water, or the like.

The dispersion medium may be a mixed solvent of water and an organic solvent for dispersion or dissolution of each component. In this case, as the organic solvent to be used, there are given acetone, acetonitrile, ethanol, methanol, isopropanol, glycerin, ethylene glycol, propylene glycol, and the like which are organic solvents miscible with water. In addition, these organic solvents may be used without being mixed with water, and each component may be dispersed or dissolved and then mixed with water. These organic solvents may be used alone or in combination of two or more kinds.

[Other components]

The polishing composition according to the present invention may further contain a known additive that may be used for the polishing composition such as a surfactant, a chelating agent, an antiseptic agent, an antifungal agent, or the like within the range where the effects of the present invention are not significantly impaired, as necessary. The polishing composition herein typically means a polishing composition used in a polishing step of a silicon wafer.

(Surfactant)

The polishing composition of the present invention may further contain a surfactant such as a nonionic surfactant, a cationic surfactant, or an anionic surfactant, as necessary. From the viewpoint of suppressing the precipitation of the above-mentioned water-soluble polymer and maintaining the performance of the polishing composition, the polishing composition of the present invention preferably further contains a nonionic surfactant.

As examples of the nonionic surfactant that can be used in the present invention, there are given alkyl betaine, alkyl amine oxide, polyoxyethylene alkyl ether, polyoxyalkylene alkyl ether, sorbitan fatty acid ester, glycerin fatty acid ester, polyoxyethylene fatty acid ester, polyoxyethylene alkylamine, alkyl alkanolamide, and the like. Among them, from the viewpoint of improving the dispersion stability of the polishing composition, polyoxyalkylene alkyl ether is preferable, and polyoxyethylene alkyl ether is more preferable. These may be used alone or in combination of two or more.

When the polishing composition is used as it is as a polishing solution, the content of the nonionic surfactant is preferably 0.00001% by weight or more, more preferably 0.00002% by weight or more, still more preferably 0.00003% by weight or more with respect to the polishing composition. Within such a range, since the dispersion stability of the polishing composition is improved, so that the polishing composition can be suitably used in a rough polishing step. When the polishing composition is used as it is as a polishing solution, the upper limit of the content of the nonionic surfactant is suitably 0.0002% by weight or less, and, from the viewpoint of maintaining a high polishing rate, preferably 0.0001% by weight or less. Further, when two or more kinds are used in combination, the content refers to the total content of two or more kinds of nonionic surfactants.

Further, when the polishing composition is diluted and used for polishing, that is, when the polishing composition is a concentrated solution, from the viewpoint of storage stability, filterability, and the like, the content of the nonionic surfactant is suitably 0.1% by weight or less in general, more preferably 0.05% by weight or less. Further, from the viewpoint of taking advantage of the concentrated solution, the content of the basic compound is preferably 0.0001% by weight or more, more preferably 0.0002% by weight or more, still more preferably 0.0005% by weight or more.

(Chelating agent)

As examples of a chelating agent that can be contained in the polishing composition, there are given an aminocarboxylic acid-based chelating agent and an organic phosphonic acid-based chelating agent. Examples of the aminocarboxylic acid-based chelating agent include ethylenediaminetetraacetic acid, sodium ethylenediaminetetraacetic acid, nitrilotriacetic acid, sodium nitrilotriacetic acid, ammonium nitrilotriacetic acid, hydroxyethylethylenediaminetriacetic acid, sodium hydroxyethylethylenediaminetriacetic acid, diethylenetriaminepentaacetic acid, sodium diethylenetriaminepentaacetic acid, triethylenetetraminehexaacetic acid, and sodium triethylenetetraminehexaacetic acid. Examples of the organic phosphonic acid-based chelating agent include 2-aminoethyl phosphonic acid, 1-hydroxyethylidene-1,1-diphosphonic acid, aminotri (methylene phosphonic acid), ethylene diamine tetrakis (methylene phosphonic acid), diethylene triamine penta (methylene phosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and $\alpha$-methylphosphonosuccinic acid. Among these, the organic phosphonic acid-based chelating agent is more preferable. As preferred ones among them, there are given ethylenediaminetetrakis (methylene phosphonic acid), diethylene triamine penta (methylene phosphonic acid), and diethylene triamine pentaacetic acid. As particularly preferred chelating agents, there are given ethylenediamine tetrakis (methylene phosphonic acid) and diethylene triamine penta (methylene phosphonic acid). The chelating agents can be used alone or in combination of two or more.

As antiseptic agents and antifungal agents that may be contained in the polishing composition, there are given, for example, isothiazoline-based antiseptic agents such as 2-methyl-4-isothiazolin-3-one and 5-chloro-2-methyl-4-isothiazolin-3-one, p-hydroxybenzoic acid esters, phenoxyethanol, and the like. These antiseptic agents and antifungal agents may be used alone or in combination of two or more kinds.

[Characteristics of polishing composition]

The polishing composition according to the present invention is typically supplied to the above-mentioned silicon wafer in the form of a polishing solution containing the polishing composition, and is used for rough polishing of the silicon wafer. The polishing composition according to the present invention may be, for example, one diluted and used as a polishing solution, or may be one used as it is as a polishing solution. Here, the dilution is typically dilution with water. The concept of the polishing composition in the technology according to the present invention includes both of a polishing solution (working slurry) supplied to a silicon wafer and used for polishing, and a concentrated solution (undiluted solution of working slurry) used for dilution and polishing. The concentration factor of the above-mentioned concentrated solution can be, for example, about 2 to 100 times on a volume basis, and is appropriately about 5 to 50 times in general.

When the polishing composition is used as it is as a polishing solution, the pH of the polishing composition is preferably 9.0 or more, more preferably 9.5 or more, still more preferably 10.0 or more, particularly preferably 10.5 or more. As the pH of the polishing composition increases, the polishing rate increases. On the other hand, when the polishing composition is used as it is as a polishing solution, the pH of the polishing composition is preferably 12.0 or less, more preferably 11.5 or less. If the pH of the polishing composition is 12.0 or less, the dissolution of the abrasive can be suppressed, and the reduction in the mechanical polishing action by the abrasive can be prevented.

Further, when the polishing composition is diluted and used for polishing, that is, when the polishing composition is a concentrated solution, the pH of the polishing composition is preferably 9.5 or more, more preferably 10.0 or more, still more preferably 10.5 or more. Further, the pH of the polishing composition is suitably 12.0 or less, preferably 11.5 or less.

Note that, the pH of the polishing composition can be measured using a pH meter. After the pH meter is calibrated at three points using a standard buffer solution, a glass electrode is put into the polishing composition. The pH of the polishing composition can be grasped by measuring the value after the pH meter becomes stable after 2 minutes or more. For example, as the pH meter, a pH glass electrode type hydrogen ion concentration indicator (model number F-23) manufactured by Horiba, Ltd. can be used. As the standard buffer solution, (1) Phthalate pH buffer solution pH: 4.01 (25°C), (2) Neutral phosphate pH buffer solution pH: 6.86 (25°C), or (3) Carbonate pH buffer solution pH: 10.01 (25°C) can be used.

The polishing composition according to the present invention may be a one-agent type or a multi-agent type including a two-agent type. The multi-agent type is a combination of solutions in which part or all of the polishing composition is mixed in any mixing ratio. Further, when a polishing machine having a plurality of supply paths for the polishing composition is used, two or more polishing compositions prepared in advance may be used so that the polishing compositions are mixed in the polishing machine.

[Method for producing polishing composition]

The polishing composition of the present invention can be obtained, for example, by stirring and mixing each component in water. However, the present invention is not limited to this method. Further, the temperature at the time of mixing each component is not particularly limited, but is preferably 10°C or more and 40°C or less, and heating may be performed to increase the rate of dissolution. Further, the mixing time is also not particularly limited.

[Polishing method]

The polishing composition according to the present invention can be used, for example, in a rough polishing step (stock polishing step) of a silicon wafer in a mode including the following operations. That is, the present invention also provides a polishing method for rough polishing a silicon wafer using the above-mentioned polishing composition.

That is, a working slurry containing the polishing composition according to the present invention is prepared. Next, the polishing composition is supplied to a silicon wafer, and rough polishing is performed by a conventional method. For example, a silicon wafer is set in a general polishing machine, and a polishing composition is supplied to the surface (surface to be polished) of the silicon wafer through a polishing pad of the polishing machine. Typically, while continuously supplying the above-mentioned polishing composition, the polishing pad is pressed against the surface of the silicon wafer to relatively move (for example, rotationally move) both. Through this polishing step, the rough polishing of the silicon wafer is completed.

The polishing pad used in the above-mentioned step is not particularly limited. For example, any of a polyurethane foam type, a non-woven type, a suede type, one containing abrasive, one not containing abrasive, and the like may be used. Further, as the above-mentioned polishing machine, a double-sided polishing machine for simultaneously polishing both surfaces of a silicon wafer may be used, or a single-sided polishing machine for polishing only one surface of a silicon wafer may be used.

The polishing conditions are not also particularly limited, but, for example, the rotation speed of the platen is preferably 10 rpm or more and 500 rpm or less, and the pressure (polishing pressure) applied to the silicon wafer is preferably 3 kPa or more and 70 kPa or less, for example, 3.45 kPa or more and 69 kPa or less. The method for supplying the polishing composition to the polishing pad is not particularly limited, and, for example, a method for continuously supplying the composition with a pump or the like is employed. Although there is no limitation on the amount supplied, it is preferable that the surface of the polishing pad is always covered with the polishing composition of the present invention.

The above-mentioned polishing composition may be used in so-called "one-way", or may be used repeatedly in recycle. Here, the term "one-way" refers to a mode in which the composition is disposed once it has been used for polishing. The following examples may be given as methods for using the polishing composition in recycle. In this method, the used polishing composition discharged from the polishing machine is recovered in a tank, and the recovered polishing composition is supplied again to the polishing machine. When the polishing composition is used in recycle, the environmental stress can be reduced. The amount of the used polishing composition to be treated as waste is reduced as compared to the case of using the polishing composition in one-way. Moreover, cost can be held down by reducing the amount of the polishing composition to be used.

[Application]

As described above, the polishing composition of the present invention is excellent in the ability to adjust the edge portion shape and the global flatness of the silicon wafer. In addition, the polishing composition of the present invention can maintain a high polishing removal rate. Taking advantages of such features, the polishing composition of the present invention is suitably used in a rough polishing step of a silicon wafer, that is, a first polishing step (stock polishing step) in a polishing step. The rough polishing step is typically performed as a double-sided polishing step that simultaneously polishes both sides of the wafer. The polishing composition according to the present invention may be preferably used also in such a double-sided polishing step.

Examples

The present invention is described in more detail by means of the following examples and comparative examples. However, the technical scope of the present invention is not limited to the following examples.

[Evaluation of etching prevention ability of water-soluble polymer]

(Preparation of slurry for evaluation)

The following components and ion-exchanged water were stirred and mixed for 30 minutes at normal temperature (25°C) so as to have a final concentration of 0.0008% by weight of a water-soluble polymer to be measured, 0.07% by weight of tetramethylammonium hydroxide (TMAH) as a basic compound, and 0.04% by weight of potassium carbonate, and then the pH was adjusted to 11 using hydrochloric acid to prepare a slurry for evaluation.

The water-soluble polymers to be measured are:

- Polyvinylpyrrolidone (weight average molecular weight 45,000, referred to as "PVP" in Table 2)
- Polyvinylpyrrolidone (weight average molecular weight 2.5 million, referred to as "PVP high molecular weight" in Table 2)
- Polyvinylimidazole (weight average molecular weight 17,000, referred to as "PVI" in Table 2)
- Polyvinyl alcohol (weight average molecular weight 10,000, saponification degree 98%, referred to as "PVA" in Table 2)
- Hydroxyethyl cellulose (weight average molecular weight 1.2 million, referred to as "HEC" in Table 2)
- Polyacrylic acid (weight average molecular weight 800,000, referred to as "PAA" in Table 2).

(Preparation of slurry for reference)

A slurry for reference was prepared in the same manner as the preparation of the above-mentioned slurry for evaluation except that the water-soluble polymer to be measured was not added.

(Evaluation of etching prevention ability)

A silicon wafer which has been cut to 30 mm × 60 mm and whose weight is measured in advance is cleaned by immersing it in a cleaning solution of $NH_4OH$ (29%) : $H_2O_2$ (31%) : deionized water (DIW) = 1: 3: 30 (volume ratio) for 30 seconds. The native oxide layer was removed by immersing the above-mentioned wafer in 5% of a hydrogen fluoride aqueous solution for 30 seconds, and then it was immersed in the above-mentioned slurry for evaluation at 25°C for 24 hours. The wafer was taken out and the weight after immersion was measured. The etching rate $R_{poly}$ was calculated based on the following equations (1) to (3) from the weight of the wafer before and after immersion, the surface area of the wafer (area of wafer surface before immersion), and the specific gravity of silicon. The specific gravity of silicon was 2.33. Similarly, the etching rate $R_{ref}$ in the case of using the slurry for reference was calculated. The etching prevention ability to silicon was calculated from $R_{poly}$ and $R_{ref}$ based on the following equation (4).
[Equation 3]

$$\Delta V = (W_0 - W_1)/d \quad (1)$$

$$\Delta x = \Delta V/S \quad (2)$$

$$R_{poly} = \Delta x/t \quad (3)$$

$\Delta V$: Wafer volume change amount before and after immersion
$W_0$: Wafer weight before immersion
$W_1$: Wafer weight after immersion
d: Specific gravity of silicon (2.33)
S: Wafer surface area
$\Delta x$: Wafer thickness change amount before and after immersion
t: Immersion time (24h)

[Equation 4]

$$\text{Etching prevention ability to silicon (\%)} = (R_{ref} - R_{poly})/R_{ref} \times 100 \quad (4)$$

[Preparation of polishing composition]

(Example 1)

The following components and ion-exchanged water were stirred and mixed for 30 minutes at normal temperature (25°C) so as to have a final concentration of 1.4% by weight of colloidal silica (average primary particle size according to BET method: 55 nm) as an abrasive, 0.0003% by weight of polyvinylpyrrolidone (PVP) (weight average molecular weight: 45,000) as a first water-soluble polymer, 0.0005% by weight of polyvinyl alcohol (PVA) (weight average molecular weight 10,000) as a second water-soluble polymer, 0.07% by weight of tetramethylammonium hydroxide (TMAH) as a basic compound, and 0.04% by weight of potassium carbonate, and then the resultant is left for 1 day or more. KOH (pH adjusting agent) was added to the solution which has been left so that the pH is adjusted to 10.5, and the polishing composition was prepared.

(Examples 2 to 5, Comparative Examples 1 to 3)

Polishing compositions according to Examples 2 to 5 and Comparative Examples 1 to 3 were prepared in the same manner as in Example 1 except that the kind and content of the water-soluble polymers were changed as shown in Table 2.

(Example 6)

A polishing composition according to Example 6 was prepared in the same manner as in Example 1 except that polyoxyethylene alkyl ether as a nonionic surfactant was further added so as to have a final concentration of 0.00004% by weight.

[Polishing performance]

Using the above-mentioned polishing composition, a silicon wafer having a size of 60 mm × 60 mm (Bare Si P-<100>) was polished under the polishing conditions shown in Table 1 below.

[Table 1]

(Table 1)

| | |
|---|---|
| Polishing machine: | Single-sided polishing machine EJ-380IN manufactured by ""Engis Japan Corporation |
| Polishing pad: | MH-S15A manufactured by Nitta Haas Incorporated |
| Polishing pressure: | 26.6 kPa |
| Slurry flow rate: | 100 ml/min |
| Platen rotation speed: | 50 rpm |
| Head rotation speed: | 40 rpm |
| Polishing removal: | 8 $\mu$m |

(Wafer thickness difference)

The thickness of the wafer after polishing was measured using DIGIMICRO MH-15M manufactured by Nikon Corporation. The measurement points were set at intervals of 10 mm in the vertical and horizontal directions in an area (50 mm × 50 mm) starting from a position at 5 mm from the wafer outer peripheral portion, and were 36 points in total. Then, the difference between the maximum value and the minimum value among the 36 points was defined as the "wafer thickness difference". Table 2 shows relative values when the wafer thickness difference in Comparative Example 1 is 100. In Table 2, it can be said that, as the value of the wafer thickness difference is smaller, the flatness of the entire wafer is higher and the global flatness is excellent.

(Roll-off amount)

The roll-off amount was evaluated by measuring the amount of shape displacement of the wafer surface after polishing using New View 5032 manufactured by Zygo Corporation. Specifically, an area at a position at 2.0 mm to 4.0 mm from the outer peripheral edge of the wafer was defined as a reference region, and a straight line (reference straight line) approximate to the shape displacement amount in the area was drawn using the least squares method. Next, a point on the above-mentioned reference straight line at a position at 2.0 mm from the outer peripheral edge was defined as a reference point, the difference between the shape displacement amount of the wafer at the position at 2.0 mm and the above-mentioned reference point was measured, and this difference was defined as "roll-off amount". Table 2 shows relative values when the roll-off amount of Comparative Example 1 is 100. In Table 2, it can be said that, as the value of the roll-off amount is smaller, the sagging at the wafer edge portion is smaller and the edge portion shape is excellent.

The results of the wafer thickness difference and the roll-off amount after polishing using each polishing composition are shown in Table 2. Further, Table 2 also shows the etching prevention ability of each water-soluble polymer calculated by the above-mentioned method.

[Table 2]

(Table 2)

| | Polishing composition | | | | | | Polishing performance | |
|---|---|---|---|---|---|---|---|---|
| | Water-soluble polymer 1 | Concentration [wt%] | Etching prevention ability [%] | water-soluble polymer 2 | Concentration [wt%] | Etching prevention ability [%] | Wafer thickness difference (Relative value) | Roll-off amount (Relative value) |
| Example 1 | PVP | 0.0003 | 75 | PVA | 0.0005 | 55 | 28 | 38 |
| Example 2 | PVI | 0.0003 | 75 | PVA | 0.0005 | 55 | 27 | 40 |
| Example 3 | PVP | 0.0003 | 75 | HEC | 0.0003 | 45 | 41 | 41 |
| Example 4 | PVP | 0.0003 | 75 | HEC | 0.0005 | 45 | 57 | 38 |
| Example 5 | PVP | 0.0003 | 75 | PAA | 0.0005 | 1 | 41 | 53 |
| Example 6 | PVP | 0.0003 | 75 | PVA | 0.0005 | 55 | 28 | 36 |
| Comparative Example 1 | None | - | - | None | - | - | 100 | 100 |
| Comparative Example 2 | PVP | 0.0003 | 75 | None | - | - | 100 | 53 |
| Comparative Example 3 | PVP | 0.0003 | 75 | PVP High molecular weight | 0.0005 | 75 | 77 | 32 |

As shown in Table 2, the silicon wafers polished using the polishing compositions according to Examples 1 to 6 had small roll off at the edge portion and good overall flatness.

On the other hand, as shown in Comparative Example 1, when the water-soluble polymer was not contained, the roll off at the edge portion was large and the overall flatness was inferior. It is suggested that since the water-soluble polymers are absent, the excessive polishing of the edge portion is promoted and also the etching action of the entire wafer is uncontrolled and non-uniformly polished. Further, as shown in Comparative Examples 2 and 3, when the water-soluble polymer was contained but the two polymers having different etching prevention ability to silicon were not contained unlike the present invention, the roll off at the wafer edge portion was relatively prevented while the flatness of the entire wafer was poor. In Comparative Example 2, it is considered that since the water-soluble polymer is consumed at the wafer edge portion and the etching prevention ability of the entire wafer cannot be controlled, the flatness of the entire wafer became poor. In Comparative Example 3, it is considered that both two kinds of PVP were consumed at the wafer edge portion and thus the overall flatness became poor.

Note that, the present application is based on Japanese Patent Application No. 2017-067956 filed on March 30, 2017, the disclosure content of which is incorporated by reference in its entirety.

## Claims

1. A polishing composition used for rough polishing a silicon wafer, comprising:

   an abrasive; water-soluble polymers; a basic compound; and water,
   wherein the water-soluble polymers include two or more polymers having different etching prevention ability to silicon.

2. The polishing composition according to claim 1,
   wherein the water-soluble polymers include a first water-soluble polymer and a second water-soluble polymer, and
   wherein etching prevention ability to silicon of the first water-soluble polymer is 70% or more, and etching prevention ability to silicon of the second water-soluble polymer is less than 70%.

3. The polishing composition according to claim 2, wherein a weight ratio of the first water-soluble polymer to the second water-soluble polymer is 5: 1 to 1: 5.

4. The polishing composition according to claim 2 or 3, wherein the second water-soluble polymer contains a hydroxyl group.

5. The polishing composition according to any one of claims 2 to 4, wherein the first water-soluble polymer contains a nitrogen atom.

6. The polishing composition according to any one of claims 2 to 5, wherein the first water-soluble polymer is polyvinyl pyrrolidone.

7. The polishing composition according to any one of claims 2 to 6, wherein the second water-soluble polymer is polyvinyl alcohol.

8. The polishing composition according to any one of claims 1 to 7, wherein a content of the water-soluble polymers is 0.002% by weight or less.

9. The polishing composition according to any one of claims 1 to 8, wherein a content of the basic compound is 0.1% by weight or more.

10. The polishing composition according to any one of claims 1 to 9, further comprising a nonionic surfactant.

11. A polishing method for rough polishing a silicon wafer using the polishing composition according to any one of claims 1 to 10.

## INTERNATIONAL SEARCH REPORT

| International application No. |
|---|
| PCT/JP2018/007546 |

### A. CLASSIFICATION OF SUBJECT MATTER
Int. Cl. H01L21/304(2006.01)i, B24B37/00(2012.01)i, C09G1/02(2006.01)i,
C09K3/14(2006.01)i

According to International Patent Classification (IPC) or to both national classification and IPC

### B. FIELDS SEARCHED
Minimum documentation searched (classification system followed by classification symbols)
Int. Cl. H01L21/304, B24B37/00, C09G1/02, C09K3/14

Documentation searched other than minimum documentation to the extent that such documents are included in the fields searched
Published examined utility model applications of Japan      1922-1996
Published unexamined utility model applications of Japan    1971-2018
Registered utility model specifications of Japan            1996-2018
Published registered utility model applications of Japan    1994-2018

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2015-67774 A (FUJIMI INC.) 13 April 2015, paragraphs [0109]-[0111], [0117], [0121], [0137], [0151]-[0154], example 4 & US 2016/0215188 A1, paragraphs [0126]-[0128], [0135], [0140], [0158], [0174]-[0180], example 4 & TW 201529680 A & CN 105612236 A & KR 10-2016-0065079 A | 1-11 |
| Y | WO 2013/108777 A1 (FUJIMI INC.) 25 July 2013, paragraphs [0018], [0026], [0027], [0081] & US 2015/0056122 A1, paragraphs [0018], [0026], [0027], [0081] & DE 112013001199 T & KR 10-2014-0117496 A & TW 201348417 A | 1-11 |

☒ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16.03.2018 | 03.04.2018 |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2018/007546

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2013/137212 A1 (FUJIMI INC.) 19 September 2013 & US 2015/0079789 A1 & DE 112013001454 T & KR 10-2014-0139541 A & TW 201350563 A | 1-11 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013165173 A
- US 2015014579 A
- JP 2017067956 A